(19) Europäisches Patentamt / European Patent Office / Office européen des brevets

(11) **EP 3 549 177 B1**

(12) **FASCICULE DE BREVET EUROPEEN**

(45) Date de publication et mention
de la délivrance du brevet:
**28.10.2020 Bulletin 2020/44**

(21) Numéro de dépôt: **17816939.7**

(22) Date de dépôt: **30.11.2017**

(51) Int Cl.:
***H01L 33/20*** *(2010.01)*

(86) Numéro de dépôt international:
**PCT/FR2017/053292**

(87) Numéro de publication internationale:
**WO 2018/100294 (07.06.2018 Gazette 2018/23)**

(54) **DISPOSITIF OPTOÉLECTRONIQUE À DIODE ÉLECTROLUMINESCENTE À EXTRACTION AUGMENTÉE**

OPTOELEKTRONISCHE VORRICHTUNG MIT LEUCHTDIODE MIT EXTRAKTIONSVERBESSERUNG

OPTOELECTRONIC DEVICE WITH LIGHT-EMITTING DIODE WITH EXTRACTION ENHANCEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2016 FR 1661877**

(43) Date de publication de la demande:
**09.10.2019 Bulletin 2019/41**

(73) Titulaire: **Commissariat à l'énergie atomique et aux énergies alternatives
75015 Paris (FR)**

(72) Inventeurs:
• **TEMPLIER, François
  38054 Grenoble Cedex 9 (FR)**
• **BOUTAMI, Salim
  38100 Grenoble (FR)**

(74) Mandataire: **Cabinet Beaumont
4, Place Robert Schuman
B.P. 1529
38025 Grenoble Cedex 1 (FR)**

(56) Documents cités:
**EP-A2- 0 977 280       WO-A2-02/089218
US-A1- 2006 192 217     US-A1- 2008 303 419
US-A1- 2009 050 905**

**Description**

Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes.

Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière.

De façon générale, le dispositif optoélectronique comprend au moins une diode électroluminescente formée par un empilement de couches semiconductrices. La zone active est la zone de la diode électroluminescente depuis laquelle est émise la majorité du rayonnement fourni par la diode électroluminescente DEL. La zone active peut comporter des moyens de confinement. A titre d'exemple, la zone active peut comprendre un puits quantique unique ou des puits quantiques multiples.

L'efficacité d'extraction d'un dispositif optoélectronique est généralement définie par le rapport entre le nombre de photons qui s'échappent du dispositif optoélectronique et le nombre de photons émis par la zone active du dispositif. Il est souhaitable que l'efficacité d'extraction d'un dispositif optoélectronique soit la plus élevée possible. Toutefois, une partie du rayonnement peut rester piégée dans le dispositif optoélectronique.

US 2006/192217 divulgue un dispositif optoélectronique comprenant une zone active adaptée à fournir un rayonnement électromagnétique et prise en sandwich entre des première et deuxième couches semiconductrices, la première couche semiconductrice délimitant une face et comprenant une première portion recouvrant au moins en partie la zone active et délimitant une première partie de la face et se prolongeant par une deuxième portion délimitant une deuxième partie de la face, la deuxième portion formant un guide d'onde, le dispositif optoélectronique comprenant une portion opaque et réfléchissante au rayonnement électromagnétique recouvrant la première partie et comprenant un réseau de diffraction dans la deuxième partie adapté à extraire le rayonnement électromagnétique de la deuxième portion.

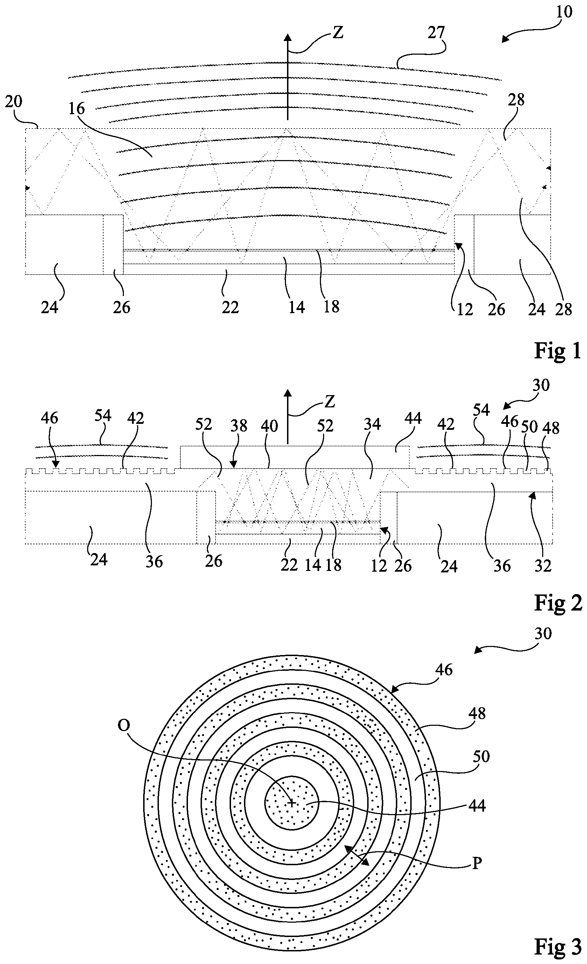

La figure 1 est une vue en coupe, partielle et schématique, d'un mode de réalisation d'un dispositif optoélectronique 10 comprenant une diode électroluminescente. A titre d'exemple, le dispositif optoélectronique 10 peut avoir une structure à symétrie de révolution. Le dispositif optoélectronique 10 comprend un empilement 12 de couches semiconductrices, par exemple comprenant majoritairement un alliage d'un élément du groupe III et d'un élément du groupe V, par exemple le GaN. L'empilement peut comprendre une couche semiconductrice 14 dopée de type P, une couche semiconductrice 16 dopée de type N et une zone active 18 prise en sandwich entre les couches semiconductrices 14 et 16. La couche semiconductrice 16 comprend une face 20, appelée face d'émission, par laquelle s'échappe le rayonnement électromagnétique émis par la zone active 18. On appelle Z la direction perpendiculaire à la face 20.

Le dispositif optoélectronique 10 comprend, en outre, un plot 22 conducteur électriquement au contact de la couche semiconductrice 14 et un plot 24 conducteur électriquement au contact de la couche semiconductrice 16. Le dispositif optoélectronique 10 comprend, en outre, une portion isolante électriquement 26 séparant le plot conducteur 24 du plot conducteur 22, de la couche semiconductrice 14 et de la zone active 18. Les plots conducteurs 22, 24 permettent d'alimenter la diode électroluminescente pour l'émission d'un rayonnement électromagnétique.

Une partie du rayonnement électromagnétique s'échappe directement par la face d'émission 20 sans que les ondes électromagnétiques ne se réfléchissent sur les parois du dispositif optoélectronique 10. Ce mode de propagation du rayonnement électromagnétique est appelé mode radiatif direct et est représenté de façon schématique en figure 1 par des fronts d'onde 27. La directivité du dispositif optoélectronique 10 correspond à la proportion du rayonnement qui s'échappe par la face d'émission 20 selon la même direction. Plus cette proportion est importante, plus le dispositif optoélectronique est directif. Les rayons lumineux du mode radiatif direct sont sensiblement orthogonaux à la face d'émission 20 de sorte que le dispositif optoélectronique 10 est directif lorsque seul le mode radiatif direct est présent.

Une partie du rayonnement électromagnétique se réfléchit sur les parois du dispositif optoélectronique 10 selon différents chemins. Ces modes de propagation sont appelés modes guidés. Des modes guidés sont représentés de façon schématique en figure 1 par des rayons 28 qui se réfléchissent sur des parois du dispositif optoélectronique 10. Au moins une partie du rayonnement électromagnétique qui se propage selon des modes guidés peut rester piégée dans le dispositif optoélectronique 10.

Il est connu de former un réseau de diffraction périodique sur la face d'émission 20 pour augmenter l'efficacité d'extraction du dispositif optoélectronique 10. Un réseau de diffraction comprend, par exemple, des rainures rectilignes ou circulaires formées dans la face d'émission 20 et régulièrement espacées. Le réseau de diffraction permet d'extraire le rayonnement se propageant dans la couche semiconductrice 16 selon des modes guidés.

Toutefois, un inconvénient du réseau périodique de diffraction est qu'il dégrade la directivité du dispositif optoélectronique 10. En effet, la direction d'émission du rayonnement par le réseau de diffraction dépend du mode guidé. L'épaisseur de la couche semiconductrice 16 peut être supérieure à quelques micromètres de sorte que le dispositif optoélectronique 10 présente généralement de nombreux modes guidés qui sont extraits par le réseau périodique de diffraction selon des directions d'émission différentes.

Résumé

Un objet de la présente invention est de pallier tout ou partie des inconvénients des dispositifs optoélectroniques décrits précédemment.

Un autre objet de la présente invention est d'augmenter l'efficacité d'extraction du dispositif optoélectronique.

Un autre objet de la présente invention est d'augmenter la directivité du dispositif optoélectronique.

Ainsi, la présente invention prévoit un dispositif optoélectronique selon la revendication 1.

Selon un mode de réalisation, le réseau de diffraction est adapté à extraire le rayonnement électromagnétique de la deuxième portion selon une direction inclinée de plus de 10° par rapport à la direction perpendiculaire à la première partie.

Selon un mode de réalisation, l'épaisseur de la deuxième portion est comprise entre 0,05 $\mu$m et 0,2 $\mu$m.

Selon un mode de réalisation, l'épaisseur de la première portion est supérieure strictement à l'épaisseur de la deuxième portion.

Selon un mode de réalisation, la dimension latérale de la deuxième portion est supérieure à la longueur d'onde dudit rayonnement électromagnétique.

Selon un mode de réalisation, le réseau de diffraction comprend des anneaux.

Selon un mode de réalisation, les anneaux sont circulaires.

Selon un mode de réalisation, les anneaux ne sont pas circulaires.

Selon un mode de réalisation, les anneaux ont la forme d'ellipses ayant un foyer commun et ayant le même grand axe.

Selon un mode de réalisation, le dispositif comprend, en outre, une couche d'un matériau au moins en partie transparent audit rayonnement électromagnétique recouvrant au moins le réseau de diffraction et dont l'indice de réfraction à la longueur d'onde dudit rayonnement électromagnétique est comprise entre l'indice de réfraction de la première couche semiconductrice à la longueur d'onde dudit rayonnement électromagnétique et l'indice de réfraction de l'air à la longueur d'onde dudit rayonnement électromagnétique.

Selon un mode de réalisation, l'épaisseur h de la deuxième portion vérifie la relation suivante :

$$h < \frac{2\lambda}{3\sqrt{n_{GaN}^2 - n_{superstrat}^2}} \qquad (I)$$

où $n_{GaN}$ est l'indice de réfraction, à la longueur d'onde du rayonnement électromagnétique émis par la zone active, du matériau composant la deuxième portion et $n_{superstrat}$ est l'indice de réfraction, à la longueur d'onde du rayonnement électromagnétique émis par la zone active, du matériau au contact de la deuxième portion par la deuxième partie de la face.

La présente invention prévoit également un procédé de fabrication d'un dispositif optoélectronique selon la revendication 13.

Selon un mode de réalisation, l'étape a) comprend la formation d'un empilement semiconducteur et la délimitation, dans l'empilement, de la zone active, de la première portion et de la deuxième portion par implantation de matériaux dans l'empilement pour dégrader localement l'empilement.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1, décrite précédemment, est une vue en coupe, partielle et schématique, d'un exemple d'un dispositif optoélectronique à diode électroluminescente ;
la figure 2 est une vue en coupe, partielle et schématique, d'un mode de réalisation d'un dispositif optoélectronique à diode électroluminescente ;
la figure 3 est une vue de dessus, partielle et schématique, d'un mode de réalisation d'un réseau de diffraction du dispositif optoélectronique de la figure 2 ;

les figures 4 à 6 représentent des diagrammes d'émission angulaire en champ lointain obtenus par simulation pour trois dispositifs optoélectroniques ayant des structures différentes ;

la figure 7 est une vue en coupe, partielle et schématique, d'un autre mode de réalisation d'un dispositif optoélectronique à diode électroluminescente ;

la figure 8 représente de façon schématique un mode de réalisation d'un réseau de diffraction du dispositif optoélectronique de la figure 2 ;

la figure 9 illustre les angles utilisés pour définir la direction d'émission d'un rayonnement par le dispositif optoélectronique à diode électroluminescente ;

la figure 10 représente de façon schématique d'autres modes de réalisation de réseaux de diffraction du dispositif optoélectronique de la figure 2 ;

la figure 11 représente un diagramme d'émission angulaire en champ lointain obtenu par simulation pour une diode électroluminescente ayant un réseau de diffraction du type de celui représenté en figure 8 ;

les figures 12A à 12J sont des vues en coupe, partielles et schématiques, des structures obtenues à des étapes successives d'un mode de réalisation d'un procédé de fabrication d'un dispositif optoélectronique du type de celui représenté sur la figure 2 ;

la figure 13 est une vue de dessus, partielle et schématique, de la structure représentée en figure 12J pour un mode de réalisation différent du dispositif optoélectronique ;

les figures 14A à 14H sont des vues en coupe, partielles et schématiques, des structures obtenues à des étapes successives d'un autre mode de réalisation d'un procédé de fabrication d'un dispositif optoélectronique du type de celui représenté sur la figure 2 ;

les figures 15A à 15D illustrent les étapes d'un mode de réalisation d'un procédé de conception d'un réseau de diffraction ; et

les figures 16 et 17 sont des vues en coupe, partielles et schématiques, d'autres modes de réalisation d'un dispositif optoélectronique à diode électroluminescente.

## Description détaillée

De mêmes éléments ont été désignés par de mêmes références dans les différentes figures. Par souci de clarté, seuls les éléments utiles à la compréhension des modes de réalisation décrits ont été représentés et sont détaillés. En particulier, la structure de la zone active d'une diode électroluminescente est bien connue de l'homme du métier et n'est pas décrite en détail par la suite. Sauf précision contraire, les expressions "approximativement", "sensiblement", et "de l'ordre de" signifient à 10 % près, de préférence à 5 % près.

La figure 2 est une vue en coupe, partielle et schématique, d'un mode de réalisation d'un dispositif optoélectronique 30 à diode électroluminescente.

Le dispositif optoélectronique 30 comprend l'ensemble des éléments du dispositif optoélectronique 10 représenté en figure 1 à la différence que la couche semiconductrice 16 est remplacée par une couche semiconductrice 32 comprenant une première portion 34 au contact de la zone active 18 et se prolongeant par une deuxième portion 36 plus fine. Selon un mode de réalisation, la couche semiconductrice 32 est dopée du type de conductivité opposé à la couche semiconductrice 14. La couche semiconductrice 32 peut être formée par un empilement d'au moins deux couches semiconductrices ayant, par exemple, des concentrations de dopants différentes. Dans le présent mode de réalisation, la deuxième portion 36 s'étend à la périphérie de la première portion 34 de sorte que la première portion 34 est appelée portion centrale et la deuxième portion 36 est appelée portion périphérique.

La couche semiconductrice 32 comprend une face avant 38 du côté opposé à la zone active 18. La face avant 38 se divise en une partie centrale 40 de la face avant 38 en vis-à-vis de la portion centrale 34 de la couche semiconductrice 32 et une partie périphérique 42 de la face avant 38 en vis-à-vis de la portion périphérique 36 de la couche semiconductrice 32. Dans le présent mode de réalisation, la partie périphérique 42 de la face avant 38 est au contact de l'air.

L'épaisseur de la portion centrale 34 peut être supérieure à quelques micromètres, par exemple comprise entre 1 $\mu$m et 10 $\mu$m. L'épaisseur de la portion périphérique 36 est inférieure à 0,2 $\mu$m, par exemple comprise entre 0,05 $\mu$m et 0,2 $\mu$m. La dimension radiale de la portion périphérique 36, mesurée perpendiculairement à la direction Z, est supérieure à la longueur d'onde du rayonnement électromagnétique et est de préférence comprise entre 1 $\mu$m et 100 $\mu$m. L'épaisseur de la portion périphérique 36 est déterminée de façon que le rayonnement puisse se propager dans la portion périphérique 36 selon un seul mode de propagation. La portion périphérique 36 correspond alors à un guide d'onde monomode.

Selon un mode de réalisation, pour assurer que le rayonnement se propage dans la portion périphérique 36 selon un seul mode de propagation, l'épaisseur h de la portion périphérique 36 est inférieure à une épaisseur maximale selon la relation (I) suivante :

$$h < \frac{2\lambda}{3\sqrt{n_{GaN}^2 - n_{superstrat}^2}} \qquad (I)$$

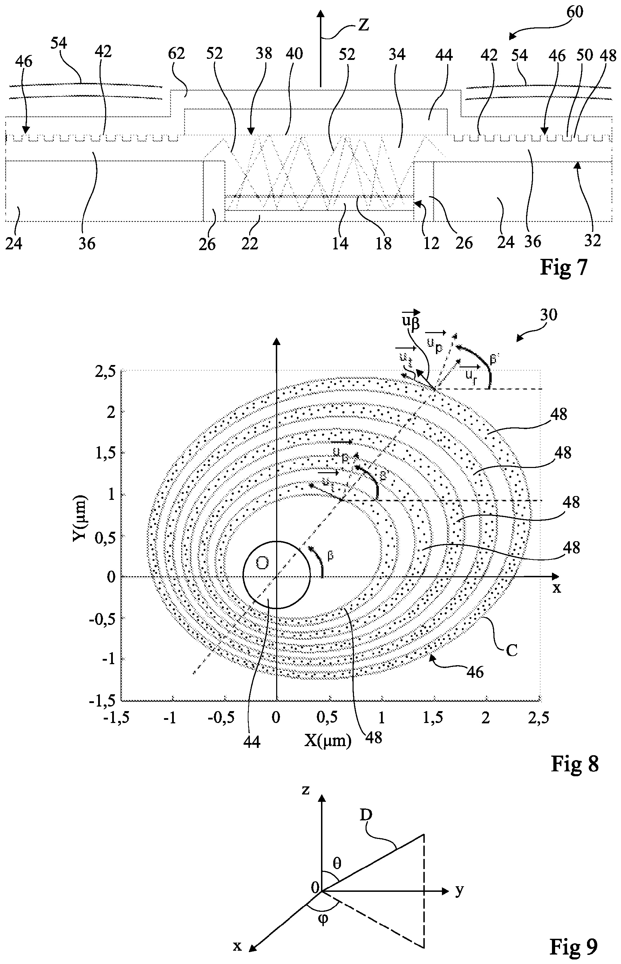

où $n_{GaN}$ est l'indice de réfraction du matériau composant la portion périphérique 36 à la longueur d'onde du rayonnement électromagnétique émis par la zone active 18 et $n_{superstrat}$ est l'indice de réfraction du matériau au contact de la portion périphérique 36 par la partie périphérique 42 de la face avant 38 à la longueur d'onde du rayonnement électromagnétique émis par la zone active 18, par exemple de l'air dans le mode de réalisation représenté en figure 2 ou d'un autre matériau comme cela est décrit par la suite en relation avec la figure 7.

Le dispositif optoélectronique 30 comprend, en outre, une portion 44 sensiblement opaque et réfléchissante au rayonnement émis par la zone active 18 et recouvrant la partie centrale 40, par exemple plane, de la face avant 38. En particulier, la portion opaque et réfléchissante 44 n'est pas présente sur la partie périphérique 42 de la face avant 38. L'épaisseur de la portion 44 est supérieure à l'épaisseur de peau à la longueur d'onde du rayonnement émis par la zone active 18. Selon un mode de réalisation, l'épaisseur de la portion 44 est supérieure à 50 nm, par exemple comprise entre 50 nm et 2000 nm. A titre d'exemple, la portion 44 est une portion métallique, par exemple en argent ou en aluminium, ayant une épaisseur supérieure à 50 nm pour être opaque à la longueur d'onde de 405 nm. La portion opaque 44 recouvre sensiblement la totalité de la zone active 18. Si la zone active 18 est de section circulaire dans un plan perpendiculaire à la direction Z, la portion opaque 44 peut avoir une section circulaire dans un plan perpendiculaire à la direction Z ayant un diamètre égal ou supérieur à celui de la zone active 18. Si la zone active 18 est de section carrée dans un plan perpendiculaire à la direction Z, la portion opaque 44 peut avoir une section circulaire dans un plan perpendiculaire à la direction Z, la section carrée de la zone active 18 étant alors inscrite dans la section circulaire de la zone active 18, ou avoir une section carrée dans un plan perpendiculaire à la direction Z de mêmes dimensions ou plus grande que la section carrée de la zone active 18.

Le dispositif optoélectronique 30 comprend, en outre, un réseau de diffraction 46 formé sur la partie périphérique 42 de la face avant 38. Le réseau de diffraction 46 comprend des portions en relief 48 et des portions en creux 50.

Selon un mode de réalisation, les couches semiconductrices de l'empilement 12 sont, au moins en partie, formées à partir d'au moins un matériau semiconducteur adapté à la formation d'une diode électroluminescente, notamment un matériau semiconducteur choisi parmi le groupe comprenant les composés III-V, les composés II-VI ou les semiconducteurs ou composés du groupe IV.

Les couches semiconductrices de l'empilement 12 peuvent être, au moins en partie, formées à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les couches semiconductrices de l'empilement 12 peuvent être, au moins en partie, formées à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les couches semiconductrices de l'empilement 12 peuvent être, au moins en partie, formées à partir de matériaux semiconducteurs comportant majoritairement au moins un élément du groupe IV. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC).

Les couches semiconductrices de l'empilement 12 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

La zone active 18 peut comporter des moyens de confinement. A titre d'exemple, la zone active 18 peut comprendre un puits quantique unique. Elle comprend alors un matériau semiconducteur différent du matériau semiconducteur formant les couches semiconductrices 14 et 32 et ayant une bande interdite inférieure à celle du matériau formant les couches semiconductrices 14 et 32. La zone active 18 peut comprendre des puits quantiques multiples. Elle comprend alors un empilement de couches semiconductrices formant une alternance de puits quantiques et de couches barrières.

L'épaisseur de la couche semiconductrice 14 peut être comprise entre 0,1 $\mu$m et 0,3 $\mu$m, par exemple environ

0,2 μm. L'épaisseur de la zone active 18 peut être comprise entre 5 nm et 300 nm, par exemple environ 0,2 μm.

Chaque plot conducteur 22, 24 peut correspondre à une couche conductrice, par exemple métallique, ou à un empilement d'au moins deux couches conductrices, par exemple métalliques. Le matériau formant chaque plot conducteur 22, 24 est, par exemple, du siliciure de nickel (NiSi), de l'aluminium (Al), du siliciure d'aluminium (AlSi), du titane (Ti) ou du siliciure de titane (TiSi). La couche 44 peut remplacer ou compléter le plot 24 comme cathode de la diode électroluminescente.

La portion isolante 26 peut être en un matériau diélectrique, par exemple en oxyde de silicium (SiO$_2$), en nitrure de silicium (Si$_x$N$_y$, où x est environ égal à 3 et y est environ égal à 4, par exemple du Si$_3$N$_4$), en oxynitrure de silicium (notamment de formule générale SiO$_x$N$_y$, par exemple du Si$_2$ON$_2$), en oxyde d'hafnium (HfO$_2$) ou en oxyde d'aluminium (Al$_2$O$_3$).

Le fonctionnement du dispositif optoélectronique 30 est le suivant. Lorsque la tension appliquée entre les plots conducteurs 22 et 24 est suffisante, des photons sont émis par la zone active 18 et se propagent dans la portion centrale 34 de la couche semiconductrice 32. La portion opaque et réfléchissante 44 empêche tout rayonnement de s'échapper par la partie centrale 40 de la face avant 38 de sorte que le dispositif optoélectronique 30 ne présente pas de mode radiatif direct. Le rayonnement se propage donc de la portion centrale 34 vers la portion périphérique 36 de la couche semiconductrice 32. Plusieurs modes guidés peuvent être présents dans la portion centrale 34 comme cela est représenté de façon schématique par plusieurs rayons 52 en figure 2. Toutefois, un seul mode guidé est possible dans la portion périphérique 36. Le réseau de diffraction 46 est défini pour faciliter l'extraction du rayonnement qui se propage selon le seul mode guidé dans la portion périphérique 36. Le rayonnement s'échappe donc par la partie périphérique 42 de la face avant 38 par l'intermédiaire du réseau de diffraction 46 comme cela est représenté de façon schématique par des fronts d'onde 54 en figure 2. Etant donné qu'il n'y a qu'un seul mode guidé qui se propage dans la portion périphérique 36, le rayonnement s'échappe par la partie périphérique 42 de la face avant 38 sensiblement selon la même direction qui dépend du réseau de diffraction 46.

L'efficacité d'extraction du dispositif optoélectronique 30 est donc augmentée. Les seules pertes sont les pertes par absorption du rayonnement électromagnétique dans les différents matériaux composant le dispositif optoélectronique 30. En outre, tout le rayonnement qui s'échappe par la partie périphérique 42 est dirigé selon la même direction. La directivité du dispositif optoélectronique 30 est de façon avantageuse augmentée.

Selon un mode de réalisation, le réseau de diffraction 46 permet l'extraction du rayonnement électromagnétique selon une direction sensiblement parallèle à la direction Z à 10° prés, c'est-à-dire de façon sensiblement orthogonale à la partie centrale 40.

La figure 3 est une vue de dessus du dispositif optoélectronique 30 et illustre un mode de réalisation du réseau de diffraction 46 dans lequel les portions en relief 48 correspondent à des anneaux circulaires concentriques et dans lequel les portions en creux 50 correspondent à des rainures circulaires et concentriques. Le réseau de diffraction 46 est périodique lorsque la distance, mesurée radialement, entre deux anneaux 48 adjacents est constante.

Si on appelle n$_{eff}$ l'indice effectif du mode guidé dans la portion périphérique 36, la période P du réseau de diffraction 46 requise pour extraire le mode guidé selon la direction Z est donnée par la relation (II) suivante :

$$P = \frac{\lambda}{n_{eff}} \qquad \text{(II)}$$

où λ est la longueur d'onde du rayonnement émis par la zone active 18. L'épaisseur des portions en relief 48 est comprise entre un dixième et la moitié de l'épaisseur de la portion périphérique 36, par exemple égale sensiblement au quart de l'épaisseur de la portion périphérique 36. Le facteur de remplissage f du réseau de diffraction 46, qui correspond au rapport entre la dimension radiale de l'anneau 48 et la période P est compris entre 25 % et 75 %, par exemple de l'ordre de 50 %.

Des simulations ont été réalisées par calcul de différences finies dans le domaine temporel. Pour ces simulations, les couches semiconductrices 14 et 16 ou 32 étaient en GaN et la zone active 18 comprenait des puits quantiques multiples comprenant une alternance de couches de GaN et de couches de AlGaN.

Une première simulation a été réalisée avec la structure du dispositif optoélectronique 10 représentée sur la figure 1. La couche semiconductrice 16 avait une épaisseur de 0,1 μm. Une deuxième simulation a été réalisée avec la structure du dispositif optoélectronique 30 représentée sur les figures 2 et 3. La portion périphérique 36 de la couche semiconductrice 32 avait une épaisseur de 1,4 μm. Pour la deuxième simulation, la portion opaque 44 n'était pas présente. Une troisième simulation a été réalisée avec la même structure que pour la deuxième simulation à la différence que la portion opaque 44 était présente.

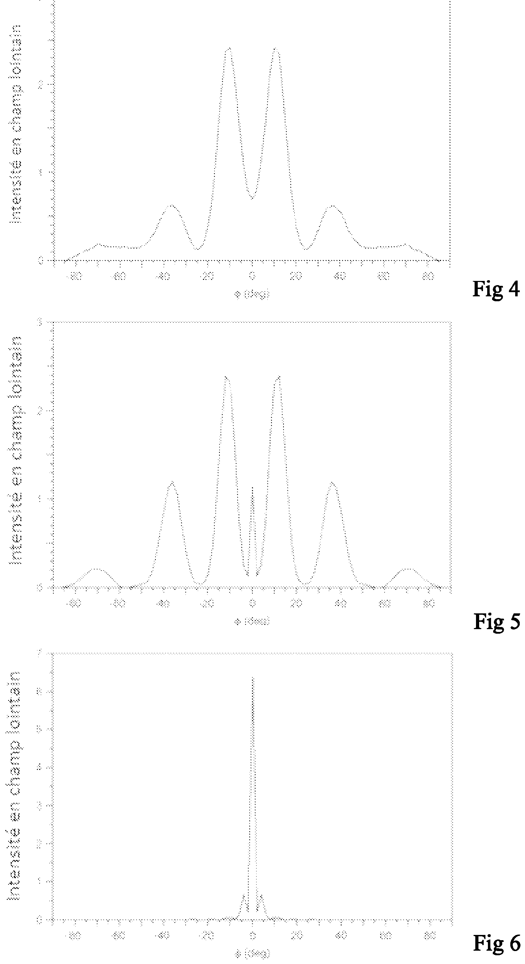

Les figures 4, 5 et 6 représentent des diagrammes d'émission angulaire en champ lointain obtenus avec les première, deuxième et troisième simulations respectivement. Comme cela apparaît sur la figure 6, l'émission obtenue pour la troisième simulation est très directive, par rapport aux émissions des dispositifs optoélectroniques des première et deuxième simulations, avec une émission à plus ou moins 1,5° par rapport à la direction Z et avec une puissance dans ce cône au moins trois fois supérieure à celle du dispositif optoélectronique de la première simulation.

La figure 7 est une vue en coupe, partielle et schématique, d'un autre mode de réalisation d'un dispositif optoélectronique 60. Le dispositif optoélectronique 60 comprend l'ensemble des éléments du dispositif optoélectronique 30 représenté en figure 2 et comprend, en outre, une couche 62 recouvrant au moins la partie périphérique 42 de la face avant 38. La couche 62 est au moins partiellement transparente à la longueur d'onde du rayonnement électromagnétique émis par la zone active 18 et est en un matériau ayant un indice de réfraction plus élevé que l'indice de réfraction de l'air à la longueur d'onde du rayonnement électromagnétique émis par la zone active 18, et plus faible que celui du matériau composant la couche semiconductrice 32. La couche 62 peut être isolante ou conductrice. Lorsque la couche 62 est conductrice, elle est, de façon avantageuse, en contact électrique avec la couche 44 et forme une cathode commune ayant une résistance faible. Dans ce cas, l'électrode 24 peut être supprimée. L'épaisseur de la couche 62 peut être comprise entre 10 nm et 2000 nm. Lorsqu'elle est en un matériau isolant, la couche 62 est par exemple en nitrure de silicium, $SiO_2$, $HfO_2$ ou en $Al_2O_3$. Lorsqu'elle est en un matériau conducteur, la couche 62 est par exemple en au moins un oxyde transparent et conducteur, notamment en oxyde de zinc et d'aluminium (AZO, sigle anglais pour Aluminium-doped Zinc Oxide), en oxyde d'indium-étain (ou ITO, sigle anglais pour Indium Tin Oxide) ou en oxyde de zinc, de gallium et d'indium (IGZO, sigle anglais pour Indium Gallium Zinc Oxide).

La présence de la couche 62 permet d'augmenter l'épaisseur de la portion périphérique 36 de la couche semiconductrice 32 tout en assurant que la portion périphérique 36 se comporte toujours comme un guide d'onde monomode. En effet, l'épaisseur maximale jusqu'à laquelle la portion périphérique 36 de la couche semiconductrice 32 se comporte comme un guide d'onde monomode augmente lorsque la différence d'indices de réfraction entre la portion périphérique 36 et la couche attenante diminue. A titre d'exemple, la couche 62 peut être réalisée en nitrure de silicium qui a un indice de réfraction égal à 2 à la longueur d'onde de 400 nm à 800 nm, en oxyde d'indium-étain (ou ITO, acronyme anglais pour Indium Tin Oxide) qui a un indice de réfraction égal à 2,1 à la longueur d'onde de 405 nm, en oxyde de zinc dopé ou non à l'aluminium ou au gallium, ou en graphène. L'épaisseur de la couche 62 peut être comprise entre 10 nm et 2000 nm.

Le réseau de diffraction 46 du mode de réalisation de la diode électroluminescente représenté sur les figures 2 et 3 est adapté à extraire le rayonnement électromagnétique émis par la zone active 18 sensiblement selon la direction Z. Toutefois, pour certaines applications, il peut être souhaitable que le rayonnement électromagnétique émis par la zone active 18 soit extrait du dispositif optoélectronique selon une direction inclinée par rapport à la direction Z. Un exemple d'application concerne les écrans affichant des images tridimensionnelles. En effet, une matrice de pixels qui émettent à des angles différents permet d'afficher des images différentes dans des directions différentes de façon à obtenir une impression de vision à trois dimensions.

La figure 8 est une vue de dessus, partielle et schématique, du dispositif optoélectronique 30 et illustre un autre mode de réalisation du réseau de diffraction 46 permettant l'extraction d'un rayonnement électromagnétique selon une direction inclinée par rapport à une direction perpendiculaire à la face avant du dispositif optoélectronique 30. En figure 8, on a représenté de façon schématique un repère orthonormé (Oxyz). Le centre O correspond au centre de la portion opaque 44, qui, à titre d'exemple, est représentée de forme circulaire. La direction (Oz) correspond à la direction Z décrite précédemment et le plan (xOy) correspond à un plan parallèle à la face avant 38 du dispositif optoélectronique 30. Dans ce repère, chaque point de la face avant 38 peut être repéré par des coordonnées polaires (r,β) ou des coordonnées cartésiennes (X,Y). On note $\vec{u_r}$ et $\vec{u_\beta}$ les vecteurs unitaires en coordonnées polaires du point de coordonnées (r,β). En figure 8, on a représenté de façon schématique les faces latérales de cinq anneaux 48 du réseau de diffraction par des courbes C.

Dans le présent mode de réalisation, on souhaite extraire la lumière du plan (xOy) suivant une direction D donnée par un angle polaire θ, par rapport à la direction Z, et un angle azimutal φ, dans le plan (xOy) comme cela est illustré sur la figure 9. Le rayonnement électromagnétique se propage sensiblement radialement dans la portion périphérique 36 avant son extraction par le réseau de diffraction 46. Le vecteur d'onde $\vec{k}_{emission}$ associé au rayonnement dans la portion périphérique 36 n'a ainsi qu'une composante radiale, et ne dépend donc vectoriellement que de l'angle β. Le vecteur d'onde $\vec{k}_{emission}$ est donné par la relation (III) suivante :

$$\vec{k}_{emission}(\beta) = \frac{2\pi}{\lambda} n_{eff} \vec{u_r} \qquad\qquad (III)$$

Quel que soit l'angle β considéré, il faut donc que le réseau de diffraction 46 soit capable d'extraire le rayonnement électromagnétique hors du plan (xOy) suivant la direction D définie par les angles θ et φ.

Selon le présent mode de réalisation, le réseau de diffraction 46 comprend des anneaux entourant le centre O qui ne sont pas de forme circulaire. Pour n'importe quel angle β, les anneaux sont disposés de façon périodique selon

la droite $(O, \vec{u}_r)$ avec une période P qui dépend seulement de l'angle β. Pour n'importe quel angle β, chaque anneau est défini par des vecteurs $\vec{u}_p$ et $\vec{u}_t$ où $\vec{u}_t$ est un vecteur unitaire dans le plan (xOy) qui est tangent à la courbe C de l'anneau et $\vec{u}_p$ est un vecteur unitaire dans le plan (xOy) qui est perpendiculaire à la courbe C du bord de l'anneau. Les vecteurs $\vec{u}_p$ et $\vec{u}_t$ ne dépendent que de l'angle β. On appelle β' l'angle entre le vecteur unitaire $\vec{u}_p$ et l'axe (Ox). L'angle β' définit la direction ou l'orientation du réseau de diffraction 46.

Le vecteur unitaire $\vec{u}_t$ est donné par la relation (IV) suivante :

$$\vec{u_t} = \begin{vmatrix} -\sin\beta' \\ \cos\beta' \end{vmatrix} \tag{IV}$$

Quel que soit l'angle β, le vecteur d'onde $\vec{k}_{extraction}$ du rayonnement électromagnétique extrait par le réseau de diffraction 46 est donné par la relation (V) suivante :

$$\vec{k}_{emission}(\beta) - \frac{2\pi}{P}\vec{u_p}(\beta) = \vec{k}_{extraction} \tag{V}$$

La relation (V) se réécrit de la façon suivante :

$$\frac{2\pi}{\lambda}n_{eff}\begin{pmatrix}\cos\beta \\ \sin\beta\end{pmatrix} - \frac{2\pi}{P}\begin{pmatrix}\cos\beta' \\ \sin\beta'\end{pmatrix} = \frac{2\pi}{\lambda}\begin{pmatrix}\sin\theta\cos\varphi \\ \sin\theta\sin\varphi\end{pmatrix}$$

On obtient après simplification la relation (VI) suivante :

$$\frac{1}{P}\begin{pmatrix}\cos\beta' \\ \sin\beta'\end{pmatrix} = \frac{1}{\lambda}\left[n_{eff}\begin{pmatrix}\cos\beta \\ \sin\beta\end{pmatrix} - \begin{pmatrix}\sin\theta\cos\varphi \\ \sin\theta\sin\varphi\end{pmatrix}\right] \tag{VI}$$

La relation vectorielle (VI) correspond à deux relations scalaires. En divisant ces deux équations scalaires, on obtient l'expression de l'angle β" selon la relation (VII) suivante :

$$\beta' = \tan^{-1}\left[\frac{n_{eff}\sin\beta - \sin\theta\sin\varphi}{n_{eff}\cos\beta - \sin\theta\cos\varphi}\right] \tag{VII}$$

En sommant ces deux équations scalaires au carré, on obtient l'expression de la période P selon la relation (VIII) suivante :

$$P = \frac{\lambda}{\sqrt{n_{eff}^2 + \sin\theta^2 - 2n_{eff}\sin\theta\cos(\varphi-\beta)}} \tag{VIII}$$

On peut déduire de la relation (VI) des configurations particulières. A titre d'exemple, l'orientation du réseau de diffraction 46 est horizontale, ce qui correspond à β' égal à 0, pour :

$$\beta = \sin^{-1}\left(\frac{\sin\theta\sin\varphi}{n_{eff}}\right) \Leftrightarrow \beta' = 0 \tag{IX}$$

Selon un autre exemple, l'orientation du réseau de diffraction 46 est verticale, ce qui correspond à β' égal à ±π/2, pour :

$$\beta = \cos^{-1}\left(\frac{\sin\theta\cos\varphi}{n_{eff}}\right) \Leftrightarrow \beta' = \pm\frac{\pi}{2} \tag{X}$$

Selon un autre exemple, on a égalité entre l'orientation du réseau et la direction radiale, ce qui correspond à β égal à β' pour :

$$\beta=\beta'=\varphi\pm\pi \qquad\qquad\qquad (XI)$$

Selon un mode de réalisation, dans un plan perpendiculaire à la direction Z, les faces latérales des anneaux 48 correspondent sensiblement à des ellipses. Selon un mode de réalisation, ces ellipses ont un foyer commun qui correspond au centre O et ont le même grand axe.

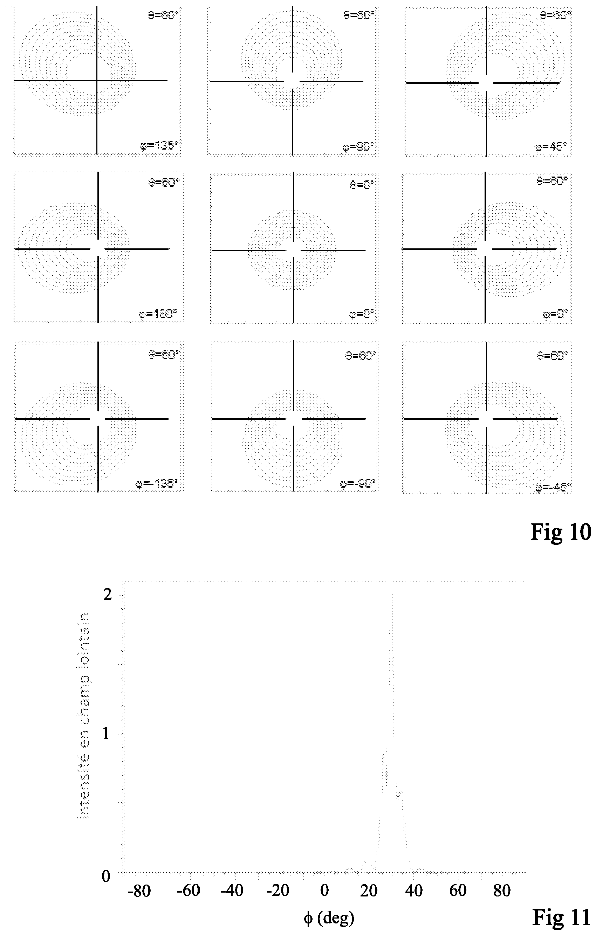

La figure 10 est une vue analogue à la figure 8 illustrant neuf configurations de réseaux de diffraction. Pour chaque réseau, on a indiqué les angles θ et φ de la direction D d'émission du rayonnement électromagnétique obtenue avec le réseau de diffraction.

La figure 11 représente un diagramme d'émission angulaire en champ lointain obtenu par simulation pour un dispositif optoélectronique 30 ayant les mêmes caractéristiques que pour l'obtention du diagramme d'émission représenté sur la figure 6 et avec un réseau de diffraction du type de celui représenté en figure 8 pour lequel la direction D d'émission du rayonnement électromagnétique est définie par les angles θ égal à 30° et φ égal à 0°. Pour le réseau de diffraction permettant d'obtenir le diagramme d'émission angulaire de la figure 6, la période P était de 205 nm. Pour le réseau de diffraction permettant d'obtenir le diagramme d'émission angulaire de la figure 11, la période P pour β égal à 0° est égale à 270 nm et la période P pour β égal à 180° est égale à 162 nm.

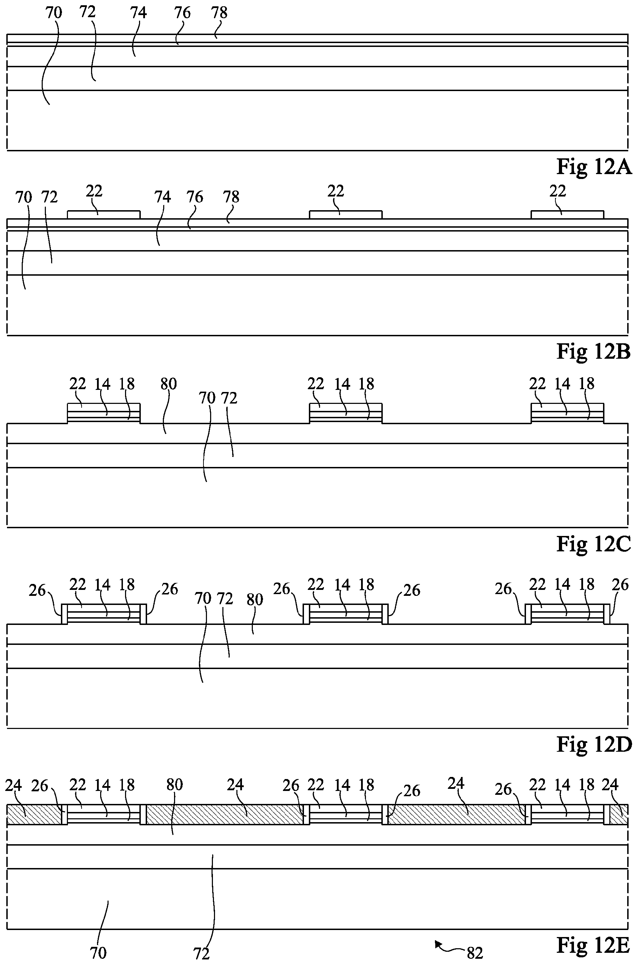

Les figures 12A à 12J sont des vues en coupe, partielles et schématiques, des structures obtenues à des étapes successives d'un mode de réalisation d'un procédé de fabrication simultanée de plusieurs exemplaires du dispositif optoélectronique 30 représenté sur la figure 2, chaque dispositif optoélectronique 30 correspondant, par exemple, à un pixel d'affichage d'un dispositif d'affichage.

Le procédé comprend les étapes successives suivantes :

(1) Formation, par exemple par épitaxie, sur un substrat 70, d'un empilement de couches semiconductrices comprenant successivement une couche intermédiaire 72, une couche 74 dopée d'un premier type de conductivité, par exemple de type N, une couche active 76 et une couche 78 dopée d'un deuxième type de conductivité, par exemple de type P, opposé au premier type de conductivité (figure 12A). Le substrat 70 peut correspondre à une structure monobloc ou correspondre à une couche recouvrant un support constitué d'un autre matériau. Le substrat 70 peut être un substrat semiconducteur, par exemple un substrat en silicium, en germanium, en carbure de silicium, en un composé III-V, tel que du GaN ou du GaAs, ou un substrat en ZnO. Le substrat 70 peut correspondre à une structure multicouches de type silicium sur isolant, également appelée SOI (acronyme anglais pour Silicon On Insulator). Le substrat 70 peut être en un matériau isolant, par exemple en saphir.

(2) Dépôt d'une couche métallique sur la couche 78 et gravure de la couche métallique pour délimiter le plot conducteur 22 pour chaque dispositif optoélectronique (figure 12B).

(3) Gravure de la couche 78, de la couche active 76 et d'une partie de l'épaisseur de la couche 74 avec arrêt de la gravure dans la couche 74 pour délimiter, pour chaque dispositif optoélectronique, la couche semiconductrice 14, la zone active 18 et une portion semiconductrice 80 (figure 12C).

(4) Dépôt d'une couche isolante électriquement sur l'ensemble de la structure et gravure anisotrope de la couche isolante électriquement pour délimiter la portion isolante 26 pour chaque dispositif optoélectronique (figure 12D).

(5) Dépôt d'une couche métallique sur l'ensemble de la structure et gravure de la couche métallique, par exemple par une planarisation mécanochimique pour délimiter le plot conducteur 24 pour chaque dispositif optoélectronique (figure 12E). On obtient ainsi un circuit optoélectronique 82.

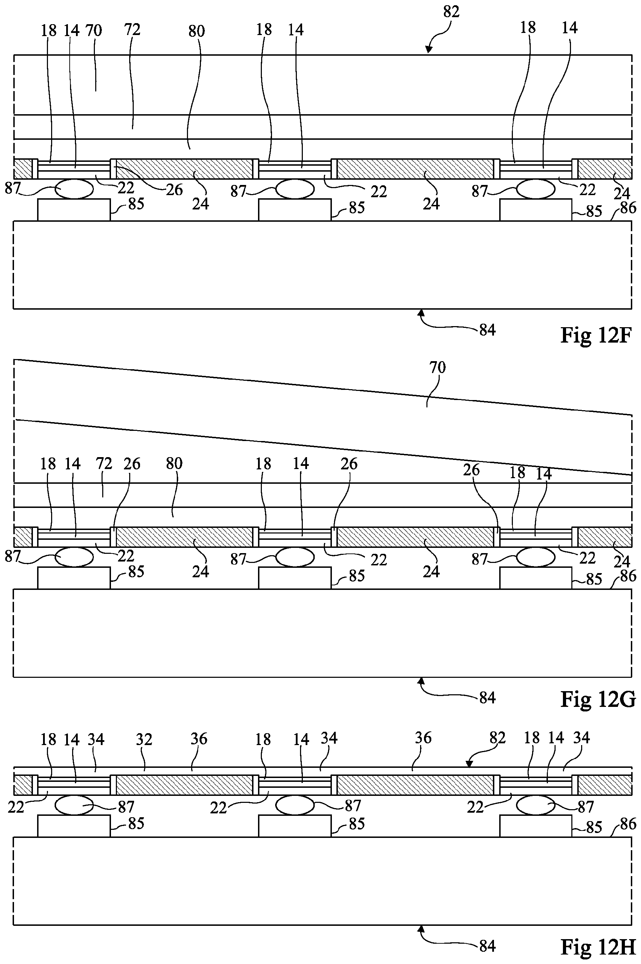

(6) Fixation du circuit optoélectronique 82 à un circuit électronique 84 (figure 12F). Le circuit électronique 84 comprend des composants électroniques non représentés. En figure 12F, on a seulement représenté des plots conducteurs 85 sur une face 86 du circuit électronique 84. Les plots conducteurs 85 sont reliés électriquement aux plots conducteurs 22 et/ou 24. Selon l'écartement entre les plots conducteurs 85, la liaison entre le circuit optoélectronique 82 et le circuit électronique 84 peut être réalisée par l'intermédiaire de billes conductrices 87 ou de microtubes.

(7) Retrait du substrat 70, par exemple par un procédé de décollement au laser (en anglais laser lift off) (figure 12G).

(8) Gravure de la totalité de la couche intermédiaire 72 et gravure partielle de la portion semiconductrice 80, seulement sur une partie de l'épaisseur de la portion semiconductrice 80, pour délimiter la couche semiconductrice 32 pour chaque dispositif optoélectronique (figure 12H).

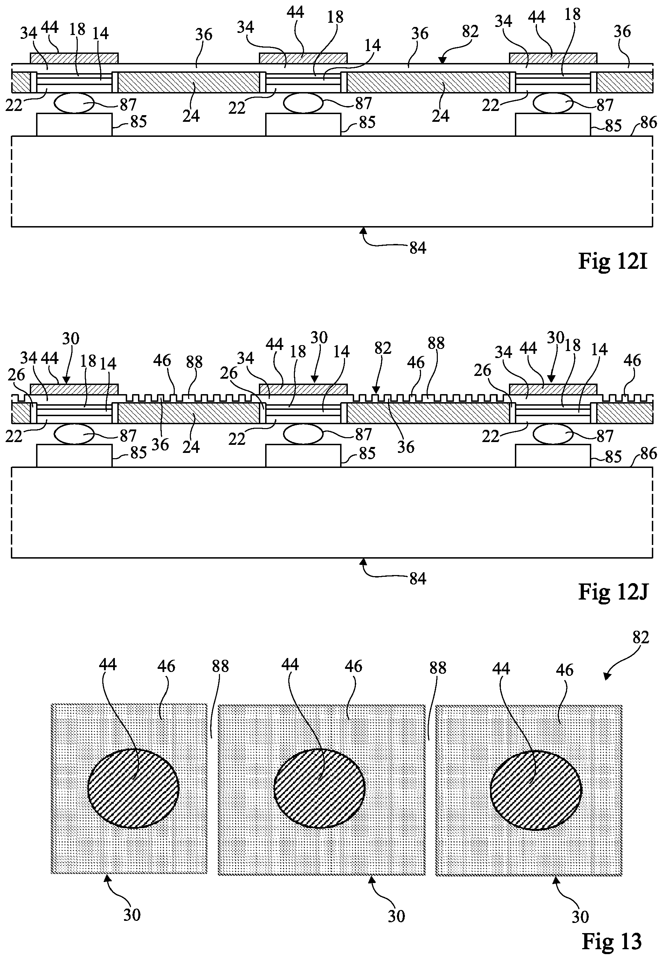

(9) Dépôt d'une couche métallique sur la couche semiconductrice 32 et gravure de la couche métallique pour délimiter la portion opaque 44 pour chaque dispositif optoélectronique (figure 12I).

(10) Formation du réseau de diffraction 46 pour chaque dispositif optoélectronique par gravure de motifs dans la portion périphérique 36 de la couche semiconductrice 32 (figure 12J). On obtient un circuit optoélectronique 82 comprenant plusieurs dispositifs optoélectroniques 30. Une zone 88 non structurée peut être laissée entre deux dispositifs optoélectroniques 30 adjacents.

Le procédé peut en outre comprendre une étape de dépôt d'une couche transparente recouvrant au moins les portions 36 pour obtenir la structure représentée en figure 7.

La figure 13 représente une vue de dessus très schématique d'un mode de réalisation du circuit optoélectronique 82 après l'étape représentée en figure 12J. Pour chaque dispositif optoélectronique 30, la portion opaque 44 est centrale et est entourée par le réseau de diffraction 46.

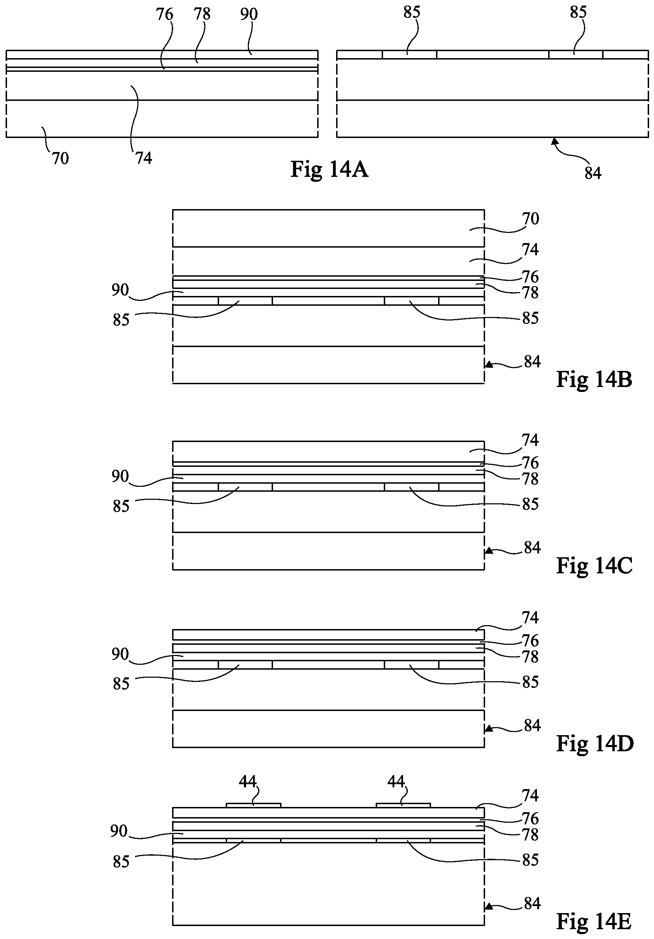

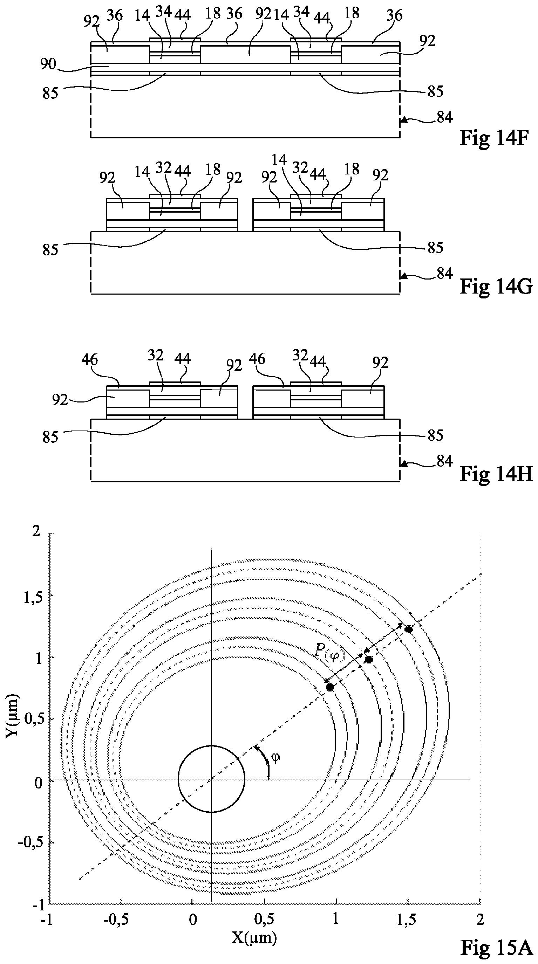

Les figures 14A à 14H sont des vues en coupe, partielles et schématiques, des structures obtenues à des étapes successives d'un autre mode de réalisation d'un procédé de fabrication simultanée de plusieurs exemplaires du dispositif optoélectronique 30 représenté sur la figure 2, chaque dispositif optoélectronique 30 correspondant, par exemple, à un pixel d'affichage d'un dispositif d'affichage.

Le procédé comprend les étapes successives suivantes :

(1') Fabrication de la même structure que celle représentée en figure 12A à la différence que la couche semiconductrice 72 n'est pas représentée et qu'une couche métallique 90 recouvre la couche 78 et fabrication séparée du circuit électronique 84 (figure 14A).

(2') Fixation du circuit optoélectronique 82 sur le circuit électronique 84, par exemple par collage (figure 14B). Les plots conducteurs 85 sont reliés électriquement à la couche métallique 90.

(3') Retrait du substrat 70 (figure 14C).

(4') Gravure de la couche semiconductrice 74 sur une partie de son épaisseur (figure 14D).

(5') Dépôt d'une couche métallique sur la couche semiconductrice 78 amincie et gravure de la couche métallique pour délimiter la portion opaque 44 de chaque dispositif optoélectronique (figure 14E).

(6') Implantation, en utilisant les portions opaques 44 comme masque, de matériaux dans la couche semiconductrice 74 sur une partie de l'épaisseur de la couche semiconductrice 74, dans la couche active 76 sur la totalité de l'épaisseur de la couche active et dans la couche semiconductrice 78 sur la totalité de l'épaisseur de la couche semiconductrice 78, pour dégrader les propriétés électroniques dans ces couches et pour former, pour chaque dispositif optoélectronique, une région 92 qui délimite la couche semiconductrice 14, la zone active 18 et la couche conductrice 32 (figure 14F). Les paramètres d'implantation sont choisis pour laisser intacte une couche superficielle de la couche semiconductrice 74 qui correspond à la portion 36 décrite précédemment. Les espèces à implanter sont choisies dans le but de dégrader électriquement les zones implantées, au sens où elles deviennent isolantes électriquement.

(7') Séparation des diodes électroluminescentes (figure 14G), par exemple par gravure successive des couches semiconductrices et de la couche métallique 90.

(8') Formation du réseau de diffraction 46 de chaque dispositif optoélectronique 30 par gravure partielle de la portion périphérique 36 de la couche semiconductrice 32 (figure 14G).

Les électrodes 44 sont reliées entre elles par des éléments non représentés (par exemple par un plan conducteur transparent ou par un niveau supplémentaire isolant puis conducteur) pour former une cathode commune. Les diodes électroluminescentes sont adressées individuellement coté anode par la matrice active (plots 85) et présentent un contact commun de cathode.

Les figures 15A à 15D illustrent des étapes successives d'un mode de réalisation d'un procédé de réalisation d'un réseau de diffraction 46 tel que celui représenté en figure 8 pour lequel la direction d'émission du rayonnement électromagnétique par le réseau de diffraction 46 n'est pas orthogonale à la face avant du dispositif optoélectronique.

Ce procédé tire parti de la relation (X) décrite précédemment. En effet, cette relation signifie que lorsque l'angle $\beta$ est égal à l'angle $\varphi$, l'angle $\beta'$ est également égal à l'angle $\varphi$. Pour cette direction particulière, les anneaux du réseau de diffraction sont orientés selon cette même direction.

Le procédé comprend les étapes successives suivantes :

- détermination du squelette de chaque anneau dans la direction $\varphi$ en tenant compte du fait que les anneaux sont parfaitement équidistants le long de la direction $\varphi$ d'une distance $P(\varphi)$ donnée par la relation (VIII) (figure 15A) ;

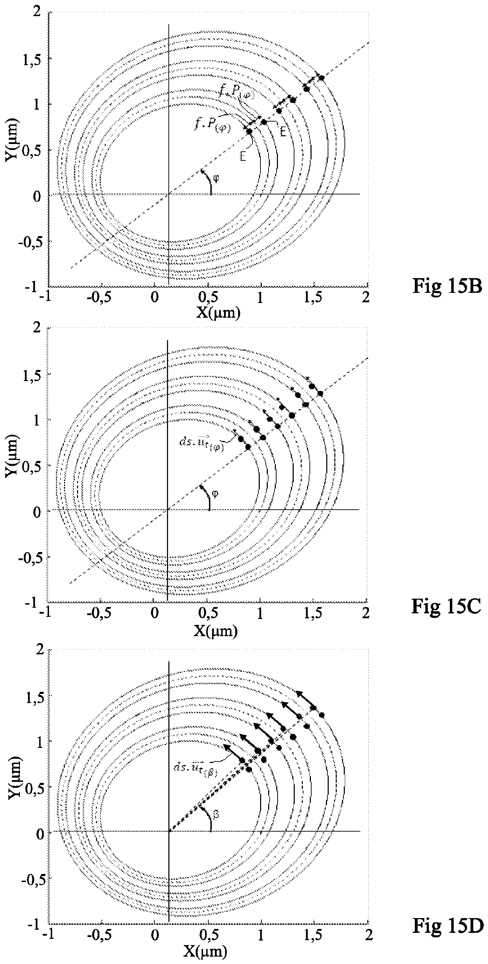

- détermination le long de la direction $\varphi$ des extrémités latérales E de chaque anneau, suivant le facteur de remplissage f choisi qui peut être égal à 50 % (figure 15B) ; et

- détermination pas à pas des anneaux par révolution, en créant de nouveaux points générés par la tangente donnée par le vecteur $\vec{u_t}$ en chaque point donné par $\beta'$ obtenu par la relation (VII) (figures 15C et 15D) .

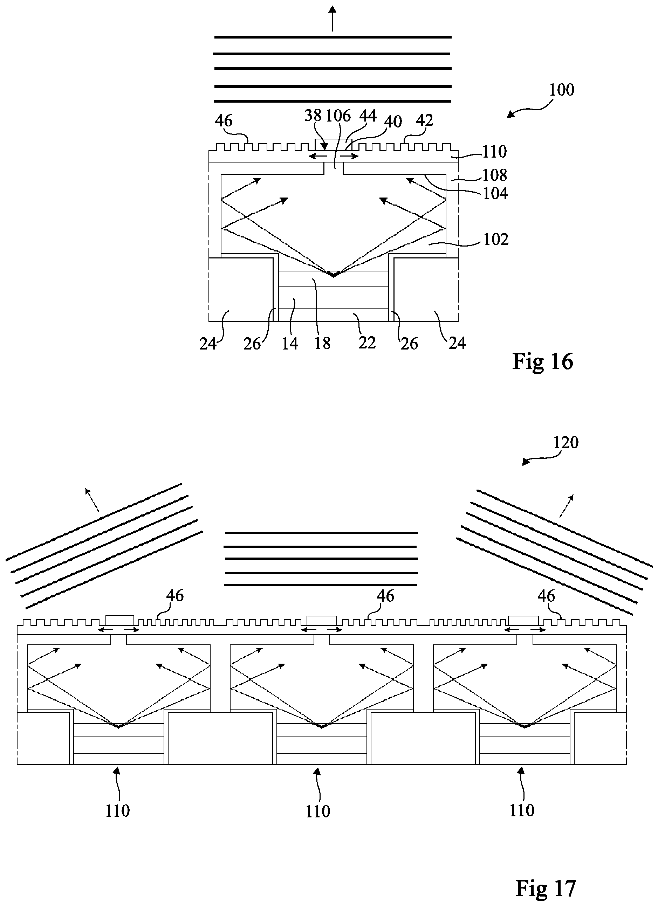

La figure 16 est une vue en coupe, partielle et schématique, d'un autre mode de réalisation d'un dispositif optoélectronique 100 à diode électroluminescente. Le dispositif optoélectronique 100 comprend l'ensemble des éléments du dispositif optoélectronique 30 représenté en figure 2 à la différence que la couche semiconductrice 32 est remplacée par une structure comprenant du bas vers le haut en figure 16 :

une couche semiconductrice 102 au contact de la zone active 18 et comprenant une face supérieure 104 ;
un plot 106 du même matériau que la couche semiconductrice 102 et se projetant en saillie par rapport à la face supérieure 104 ;
une couche intermédiaire 108 entourant la couche semiconductrice 102, et en particulier recouvrant la totalité de la face supérieure 104, entourant le plot 106 mais ne recouvrant pas le plot 106 ; et
une couche 110 recouvrant la couche intermédiaire 108 et au contact du plot 106.

La couche semiconductrice 102 peut être composée du même matériau que la couche semiconductrice 32. La couche 110 peut être dans le même matériau que la couche semiconductrice 102 ou en un matériau différent. Selon un mode de réalisation, la couche 110 est en oxyde de titane ($TiO_2$), en nitrure de silicium (SiN) ou en oxyde de tantale ($Ta_2O_5$). La couche 108 peut être composée du même matériau que le plot conducteur 24.

L'épaisseur de la couche 110 est déterminée de façon que le rayonnement puisse se propager dans la couche 110 selon un seul mode de propagation. La couche 110 correspond alors à un guide d'onde monomode. De même, les dimensions du plot 106 sont déterminées de façon que le rayonnement puisse se propager dans le plot selon un seul mode de propagation. Le plot 106 correspond alors à un guide d'onde monomode.

La face avant 38 est délimitée par la couche 110. Comme cela a été décrit précédemment, la face avant 38 se divise en la partie centrale 40, recouverte par la portion 44 sensiblement opaque et réfléchissante au rayonnement émis par la zone active 18, et la partie périphérique 42 au niveau de laquelle est formé le réseau de diffraction 46.

A la différence du dispositif optoélectronique 30 représenté en figure 2, dans le mode de réalisation représenté en figure 16, la portion opaque 44, également appelée capot opaque, ne recouvre pas toute la zone active 18 mais peut seulement recouvrir le plot 106.

Un mode de réalisation d'un procédé de fabrication du dispositif optoélectronique 110 comprend les mêmes étapes que celles décrites précédemment en relation avec les figures 12A à 12G à la différence que la couche 32 est remplacée par la couche 102. L'étape décrite précédemment en relation avec la figure 12H est remplacée par les étapes suivantes :

éventuel amincissement de la couche 102 ;
délimitation latérale de la couche 102 pour chaque pixel ;
gravure de la couche 102 en surface pour former le plot 106 pour chaque pixel ;
formation de la couche 108 ; et
dépôt de la couche 110.

Selon un mode de réalisation, le procédé se poursuit avec les étapes décrites précédemment en relation avec les figures 12I et 12J à la différence que les étapes sont réalisées sur la couche 110 au lieu de la couche 32.

La figure 17 est une vue en coupe, partielle et schématique, d'un autre mode de réalisation d'un dispositif optoélectronique 120 à diode électroluminescente. Le dispositif optoélectronique 120 comprend plusieurs exemplaires du dispositif optoélectronique 110 représenté en figure 16 qui jouent chacun le rôle d'un pixel, les réseaux de diffraction 46 des dispositifs optoélectroniques 110 étant adaptés pour des pixels émettant dans des directions différentes.

Des modes de réalisation particuliers ont été décrits. Diverses variantes et modifications apparaîtront à l'homme de l'art. Bien que dans les modes de réalisation décrits précédemment, les réseaux de diffraction comprennent des anneaux, la structure des réseaux de diffraction peut être différente.

**Revendications**

1. Dispositif optoélectronique (30 ; 60) comprenant une zone active (18) adaptée à fournir un rayonnement électromagnétique et prise en sandwich entre des première et deuxième couches semiconductrices (14, 32, 102), le dispositif optoélectronique comprenant une troisième couche semiconductrice (110), intégrée à la première couche semiconductrice ou en contact avec la première couche semiconductrice, la troisième couche semiconductrice délimitant une face (38) et comprenant une première portion (34) recouvrant au moins en partie la zone active et délimitant une première partie (40) de la face et se prolongeant par une deuxième portion (36) délimitant une deuxième partie (42) de la face, la deuxième portion formant un guide d'onde monomode, le dispositif optoélectronique comprenant une portion (44) opaque et réfléchissante au rayonnement électromagnétique recouvrant la première partie et comprenant un réseau de diffraction (46) dans la deuxième partie adapté à extraire le rayonnement électromagnétique de la deuxième portion.

**2.** Dispositif optoélectronique selon la revendication 1, dans lequel le réseau de diffraction (46) est adapté à extraire le rayonnement électromagnétique de la deuxième portion (36) selon une direction inclinée de plus de 10° par rapport à la direction perpendiculaire à la première partie (40).

**3.** Dispositif optoélectronique selon la revendication 1 ou 2, dans lequel l'épaisseur de la deuxième portion (36) est comprise entre 0,05 $\mu$m et 0,2 $\mu$m.

**4.** Dispositif optoélectronique selon la revendication 3, dans lequel l'épaisseur de la première portion (34) est supérieure strictement à l'épaisseur de la deuxième portion (36).

**5.** Dispositif optoélectronique selon l'une quelconque des revendications 1 à 4, dans lequel la dimension latérale de la deuxième portion (36) est supérieure à la longueur d'onde dudit rayonnement électromagnétique.

**6.** Dispositif optoélectronique selon l'une quelconque des revendications 1 à 5, dans lequel le réseau de diffraction (46) comprend des anneaux (48).

**7.** Dispositif optoélectronique selon la revendication 6, dans lequel les anneaux (48) sont circulaires.

**8.** Dispositif optoélectronique selon la revendication 6, dans lequel les anneaux (48) ne sont pas circulaires.

**9.** Dispositif optoélectronique selon la revendication 8, dans lequel les anneaux (48) ont la forme d'ellipses ayant un foyer commun et ayant le même grand axe.

**10.** Dispositif optoélectronique selon l'une quelconque des revendications 1 à 9, comprenant, en outre, une couche (62) d'un matériau au moins en partie transparent audit rayonnement électromagnétique recouvrant au moins le réseau de diffraction (46) et dont l'indice de réfraction à la longueur d'onde dudit rayonnement électromagnétique est comprise entre l'indice de réfraction de la troisième couche semiconductrice à la longueur d'onde dudit rayonnement électromagnétique et l'indice de réfraction de l'air à la longueur d'onde dudit rayonnement électromagnétique.

**11.** Dispositif optoélectronique selon l'une quelconque des revendications 1 à 10, dans lequel l'épaisseur h de la deuxième portion (36) vérifie la relation (I) suivante :

$$h < \frac{2\lambda}{3\sqrt{n_{GaN}^2 - n_{superstrat}^2}} \qquad (I)$$

où $n_{GaN}$ est l'indice de réfraction, à la longueur d'onde du rayonnement électromagnétique émis par la zone active (18), du matériau composant la deuxième portion et $n_{superstrat}$ est l'indice de réfraction, à la longueur d'onde du rayonnement électromagnétique émis par la zone active, du matériau au contact de la deuxième portion par la deuxième partie (42) de la face (38).

**12.** Dispositif optoélectronique selon l'une quelconque des revendications 1 à 11, dans lequel le réseau de diffraction (46) est adapté à extraire le rayonnement électromagnétique de la deuxième portion (36) selon une direction sensiblement perpendiculaire à la première partie (40) à 10° près.

**13.** Procédé de fabrication d'un dispositif optoélectronique (30 ; 60) comprenant une zone active (18) adaptée à fournir un rayonnement électromagnétique prise en sandwich entre des première et deuxième couches semiconductrices (14, 32, 102), et comprenant une troisième couche semiconductrice (110), intégrée à la première couche semiconductrice ou en contact avec la première couche semiconductrice, la troisième couche semiconductrice délimitant une face (38), le procédé comprenant les étapes suivantes :

a) former, dans la troisième couche semiconductrice, une première portion (34) recouvrant au moins en partie la zone active et délimitant une première partie (40) de la face et se prolongeant par une deuxième portion (36) délimitant une deuxième partie (42) de la face, la deuxième portion formant un guide d'onde monomode ;
b) former une portion (44) opaque au rayonnement électromagnétique recouvrant la première partie ; et
c) former un réseau de diffraction (46) dans la deuxième partie adapté à extraire le rayonnement électromagnétique de la deuxième portion.

**14.** Procédé selon la revendication 13, dans lequel l'étape a) comprend la formation d'un empilement (12) semiconducteur et la délimitation, dans l'empilement, de la zone active (18), de la première portion (34) et de la deuxième portion (36) par implantation de matériaux dans l'empilement pour dégrader localement l'empilement.

**Patentansprüche**

**1.** Optoelektronisches Bauelement (30; 60) mit einem aktiven Bereich (18), der in der Lage ist, eine elektromagnetische Strahlung zu liefern und zwischen einer ersten und einer zweiten Halbleiterschicht (14, 32, 102) angeordnet ist, wobei das optoelektronische Bauelement eine dritte Halbleiterschicht (110) aufweist, die in die erste Halbleiterschicht integriert ist oder mit der ersten Halbleiterschicht in Kontakt steht, wobei die dritte Halbleiterschicht eine Oberfläche (38) begrenzt und einen ersten Abschnitt (34) aufweist, der wenigstens teilweise den aktiven Bereich bedeckt und einen ersten Teil (40) der Oberfläche begrenzt und sich in einem zweiten Abschnitt (36) fortsetzt, der einen zweiten Teil (42) der Oberfläche begrenzt, wobei der zweite Abschnitt einen Einmoden-Wellenleiter bildet, wobei das optoelektronische Bauelement einen opaken, für elektromagnetische Strahlung reflektierenden Abschnitt (44) aufweist, der den ersten Teil bedeckt, und in dem zweiten Teil ein Beugungsgitter (46) aufweist, das in der Lage ist, die elektromagnetische Strahlung aus dem zweiten Abschnitt zu extrahieren.

**2.** Optoelektronisches Bauelement nach Anspruch 1, wobei das Beugungsgitter (46) in der Lage ist, die elektromagnetische Strahlung aus dem zweiten Teil (36) entlang einer Richtung zu extrahieren, die um mehr als 10° relativ zu der Richtung senkrecht zu dem ersten Teil (40) geneigt ist.

**3.** Optoelektronisches Bauelement nach Anspruch 1 oder 2, wobei die Dicke des zweiten Teils (36) im Bereich von 0,05 $\mu$m bis 0,2 $\mu$m liegt.

**4.** Optoelektronisches Bauelement nach Anspruch 3, wobei die Dicke des ersten Abschnitts (34) größer ist als die Dicke des zweiten Abschnitts (36).

**5.** Optoelektronisches Bauelement nach einem der Ansprüche 1 bis 4, wobei die seitliche Abmessung des zweiten Abschnitts (36) größer als die Wellenlänge der elektromagnetischen Strahlung ist.

**6.** Optoelektronisches Bauelement nach einem der Ansprüche 1 bis 5, wobei das Beugungsgitter (46) Ringe (48) aufweist.

**7.** Optoelektronisches Bauelement nach Anspruch 6, wobei die Ringe (48) kreisförmig sind.

**8.** Optoelektronisches Bauelement nach Anspruch 6, wobei die Ringe (48) nicht kreisförmig sind.

**9.** Optoelektronisches Bauelement nach Anspruch 8, wobei die Ringe (48) die Form von Ellipsen mit einem gemeinsamen Brennpunkt und derselben Hauptachse haben.

**10.** Optoelektronisches Bauelement nach einem der Ansprüche 1 bis 9, ferner aufweisend eine Schicht (62) aus einem Material, das wenigstens teilweise für die elektromagnetische Strahlung transparent ist, wenigstens das Beugungsgitter (46) bedeckt und einen Brechungsindex bei der Wellenlänge der elektromagnetischen Strahlung hat der in dem Bereich zwischen dem Brechungsindex der dritten Halbleiterschicht bei der Wellenlänge der elektromagnetischen Strahlung und dem Brechungsindex von Luft bei der Wellenlänge der elektromagnetischen Strahlung liegt.

**11.** Optoelektronisches Bauelement nach einem der Ansprüche 1 bis 10, wobei die Dicke h des zweiten Abschnitts (36) die folgende Beziehung (I) erfüllt:

$$h < \frac{2\lambda}{3\sqrt{n_{GaN}^2 - n_{superstrat}^2}} \tag{I}$$

wobei $n_{GaN}$ der Brechungsindex, bei der Wellenlänge der von der aktiven Fläche (18) emittierten elektromagnetischen Strahlung, des den zweiten Abschnitt bildenden Materials ist, und $n_{superstrat}$ der Brechungsindex, bei der Wellenlänge der von der aktiven Fläche emittierten elektromagnetischen Strahlung, des Materials ist, das mit dem zweiten Abschnitt durch den zweiten Teil (42) der Oberfläche (38) in Kontakt ist.

12. Optoelektronisches Bauelement nach einem der Ansprüche 1 bis 11, wobei das Beugungsgitter (46) geeignet ist die elektromagnetische Strahlung aus dem zweiten Teil (36) innerhalb von 10° entlang einer Richtung im Wesentlichen senkrecht zum ersten Teil (40) zu extrahieren.

13. Verfahren zur Herstellung eines optoelektronischen Bauelements (30; 60) mit einem aktiven Bereich (18), der in der Lage ist, eine elektromagnetische Strahlung zu liefern, und der zwischen einer ersten und einer zweiten Halbleiterschicht (14, 32, 102) angeordnet ist, und mit einer dritten Halbleiterschicht (110), die in die erste Halbleiterschicht integriert ist oder in Kontakt mit der ersten Halbleiterschicht steht, wobei die dritte Halbleiterschicht eine Oberfläche (38) begrenzt, wobei das Verfahren die folgenden Schritte aufweist

a) Bilden, in der dritten Halbleiterschicht, eines ersten Abschnitts (34), der wenigstens teilweise den aktiven Bereich bedeckt und einen ersten Teil (40) der Oberfläche begrenzt und durch einen zweiten Abschnitt (36) fortgesetzt wird, der einen zweiten Teil (42) der Oberfläche begrenzt, wobei der zweite Abschnitt einen Einmoden-Wellenleiter bildet;
b) Bilden eines Abschnitts (44), der für elektromagnetische Strahlung undurchlässig ist und den ersten Teil bedeckt; und
c) Bilden eines Beugungsgitters (46) im zweiten Teil, das in der Lage ist, die elektromagnetische Strahlung aus dem zweiten Teil zu extrahieren.

14. Verfahren nach Anspruch 13, wobei Schritt a) das Bilden eines Halbleiterstapels (12) und das begrenzen des aktiven Bereichs (18), des ersten Abschnitts (34) und des zweiten Abschnitts (36) in dem Stapel durch Implantation von Materialien in den Stapel aufweist, um den Stapel lokal zu degradieren.

**Claims**

1. An optoelectronic device (30; 60) comprising an active area (18) capable of supplying an electromagnetic radiation and sandwiched between first and second semiconductor layers (14, 32, 102), the optoelectronic device comprising a third semiconductor layer (110), integrated to the first semiconductor layer or in contact with the first semiconductor layer, the third semiconductor layer delimiting a surface (38) and comprising a first portion (34) at least partially covering the active area and delimiting a first part (40) of the surface and being continued by a second portion (36) delimiting a second part (42) of the surface, the second portion forming a single-mode waveguide, the optoelectronic device comprising an opaque portion (44) which is reflective for electromagnetic radiation, covering the first part, and comprising a diffraction grating (46) in the second part capable of extracting the electromagnetic radiation from the second portion.

2. The optoelectronic device of claim 1, wherein the diffraction grating (46) is capable of extracting the electromagnetic radiation from the second portion (36) along a direction inclined by more than 10° relative to the direction perpendicular to the first part (40).

3. The optoelectronic device of claim 1 or 2, wherein the thickness of the second portion (36) is in the range from 0.05 $\mu$m to 0.2 $\mu$m.

4. The optoelectronic device of claim 3, wherein the thickness of the first portion (34) is greater than the thickness of the second portion (36).

5. The optoelectronic device of any of claims 1 to 4, wherein the lateral dimension of the second portion (36) is greater than the wavelength of said electromagnetic radiation.

6. The optoelectronic device of any of claims 1 to 5, wherein the diffraction grating (46) comprises rings (48).

7. The optoelectronic device of claim 6, wherein the rings (48) are circular.

8. The optoelectronic device of claim 6, wherein the rings (48) are not circular.

9. The optoelectronic device of claim 8, wherein the rings (48) have the shape of ellipses having a common focus and having the same major axis.

10. The optoelectronic device of any of claims 1 to 9, further comprising a layer (62) of a material at least partly transparent to said electromagnetic radiation, covering at least the diffraction grating (46) and having a refractive index at the wavelength of said electromagnetic radiation in the range from the refractive index of the third semiconductor layer at the wavelength of said electromagnetic radiation to the refractive index of air at the wavelength of said electromagnetic radiation.

11. The optoelectronic device of any of claims 1 to 10, wherein thickness h of the second portion (36) verifies the following relation (I):

$$h < \frac{2\lambda}{3\sqrt{n_{GaN}^2 - n_{superstrat}^2}} \tag{I}$$

where $n_{GaN}$ is the refractive index, at the wavelength of the electromagnetic radiation emitted by the active area (18), of the material forming the second portion and $n_{superstrat}$ is the refractive index, at the wavelength of the electromagnetic radiation emitted by the active area, of the material in contact with the second portion by the second part (42) of the surface (38).

12. The optoelectronic device of any of claims 1 to 11, wherein the diffraction grating (46) is adapted to extract the electromagnetic radiation from the second portion (36) along a direction substantially perpendicular to the first part (40) within 10 °.

13. A method of manufacturing an optoelectronic device (30; 60) comprising an active area (18) capable of supplying an electromagnetic radiation, sandwiched between first and second semiconductor layers (14, 32, 102), and comprising a third semiconductor layer (110), integrated to the first semiconductor layer or in contact with the first semiconductor layer, the third semiconductor layer delimiting a surface (38), the method comprising the steps of:

   a) forming, in the third semiconductor layer, a first portion (34) at least partially covering the active area and delimiting a first part (40) of the surface and being continued by a second portion (36) delimiting a second part (42) of the surface, the second portion forming a single-mode waveguide;
   b) forming a portion (44) opaque to electromagnetic radiation, covering the first part; and
   c) forming a diffraction grating (46) in the second part capable of extracting the electromagnetic radiation from the second portion.

14. The method of claim 13, wherein step a) comprises forming a semiconductor stack (12) and delimiting, in the stack, the active area (18), the first portion (34), and the second portion (36) by implantation of materials in the stack to locally degrade the stack.

Fig 1

Fig 2

Fig 3

Fig 4

Fig 5

Fig 6

Fig 7

Fig 8

Fig 9

Fig 10

Fig 11

Fig 12A

Fig 12B

Fig 12C

Fig 12D

Fig 12E

18 14 70 72 80 18 14 82 18 14

87 22 26 24 87 22 24 87 22 24
85 85 85 86

84 **Fig 12F**

70

18 14 72 26 80 18 14 26 26 18 14

87 22 26 24 87 22 24 87 22 24
85 85 85 86

84 **Fig 12G**

18 14 34 32 36 18 14 34 36 82 18 14 34

22 87 22 87 22 87
85 85 85 86

84 **Fig 12H**

Fig 12I

Fig 12J

Fig 13

76  78  90                    85                    85

**Fig 14A**

70          74          84

─────────

70
74
90   76
85   78
85
84

**Fig 14B**

─────────

74
90   76
85   78
85
84

**Fig 14C**

─────────

74
90   76
85   78
85
84

**Fig 14D**

─────────

44          44
90                    74
85   76
78
85
84

**Fig 14E**

Fig 14F

Fig 14G

Fig 14H

Fig 15A

Fig 15B

Fig 15C

Fig 15D

**Fig 16**

**Fig 17**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2006192217 A